# EUROPÄISCHE PATENTSCHRIFT

(11) **EP 3 050 740 B1**
(45) Veröffentlichungstag und Bekanntmachung des Hinweises auf die Patenterteilung: **13.03.2019**
(21) Anmeldenummer: 15003249.8
(22) Anmeldetag: 13.11.2015
(51) Int. Cl.: B60L 11/18, H01M 10/44, H02J 7/00, B60L 3/12, H02J 7/04, G01R 31/36, B60L 3/00, B60L 3/04, H01M 10/48

(54) **VERFAHREN UND VORRICHTUNG ZUR TEMPERATURABHÄNGIGEN STROMBEGRENZUNG EINES ENERGIESPEICHERS FÜR ELEKTRISCHE ENERGIE**
METHOD AND DEVICE FOR THE TEMPERATURE-DEPENDENT CURRENT LIMITATION OF AN ENERGY STORAGE DEVICE FOR ELECTRICAL ENERGY
PROCÉDÉ ET DISPOSITIF DE LIMITATION DE COURANT EN FONCTION DE LA TEMPÉRATURE POUR UN SYSTÈME DE STOCKAGE D'ÉNERGIE ÉLECTRIQUE

(30) Priorität: 29.01.2015 DE 102015001069
(43) Veröffentlichungstag der Anmeldung: 03.08.2016
(73) Patentinhaber: MAN Truck & Bus AG, 80995 München (DE)
(72) Erfinder: Kratzer, Sebastian, 85757 Karlsfeld (DE); Büschel, Susanne, 80809 München (DE); Müller, Bernd, 80689 München (DE)
(74) Vertreter: v. Bezold & Partner Patentanwälte - PartG mbB

(56) Entgegenhaltungen:
- EP-A1- 2 712 018
- EP-A1- 2 824 753
- DE-T5-112010 005 527
- US-A1- 2006 152 196
- US-A1- 2009 085 527
- US-A1- 2009 153 104
- US-A1- 2013 181 683

## Beschreibung

Die Erfindung betrifft ein Verfahren und eine Vorrichtung zur temperaturabhängigen Strombegrenzung eines Energiespeichers für elektrische Energie.

Aus dem Stand der Technik bekannte Hochvoltbatterien von Mildhybrid-, Hybrid- oder Elektrofahrzeugen, auch Batteriepacks genannt, bestehen aus vielen in Reihe und/oder parallel geschalteten Einzelzellen, z. B. Lithium-Ionen-Zellen. Es ist bekannt, dass die Temperatur der Zellen sowohl im Betrieb als auch während des Fahrzeugstillstandes die Lebensdauer der Hochvoltbatterie beeinflusst, wobei insbesondere zu hohe Temperaturen abträglich für die Lebensdauer sind.

Zur Begrenzung der temperaturbedingten Alterung ist es aus dem Stand der Technik, beispielsweise der DE 10 2007 063 178 A1, DE 10 2007 010 751 A1 oder WO 2010/121831 A1, bekannt, dass derartige Hochvolt-Batterien mittels eines Kühlsystems und fluiddurchströmten Kühlplatten temperiert werden, um eine entstehende Verlustwärme abzuführen, damit der zulässige Betriebsbereich für die Temperatur des elektrischen Energiespeichers nicht verletzt wird.

Aus der Praxis ist zur Begrenzung der thermischen Belastung des Energiespeichers ferner bekannt, einen maximal zulässigen Lade- und/oder Entladestrom des Energiespeichers vorzugeben, d. h. eine obere Grenze des zulässigen Stroms festzulegen, mit welchem der Energiespeicher für eine Dauer eines vorgegebenen Zeitintervalls geladen werden kann oder welcher dem Energiespeicher für die Dauer eines vorgegebenen Zeitintervalls entnommen werden kann, um feste Temperaturgrenzwerte nicht zu überschreiten. Derartige Grenzwerte können im Hinblick auf eine gewünschte Lebensdauer des Energiespeichers aus- bzw. festgelegt werden. Nachteilig hieran ist jedoch, dass die Vorgabe solch fixer Temperaturgrenzwerte für den Lade- und/oder Entladestrom des Energiespeichers mit einer verringerten Leistungsfähigkeit und Flexibilität in Bezug auf die Bedienung kurzfristig hoher Leistungsanforderungen einhergeht.

Aus der EP 2 712 018 A1 ist eine Schutzvorrichtung für eine sekundäre Batterie bekannt, die anhand von Spannungs- und Temperaturwerten überprüft, ob eine erste bzw. zweite Anschwellbedingung betreffend die Batterie erfüllt ist. Hierbei werden insbesondere auch Mittelwerte der Batterietemperatur bestimmt. In Abhängigkeit von der erfassten Anschwellbedingung wird der Ladestrom bzw. die Spannung angepasst oder der Entlade- oder Ladevorgang beendet. Zwar kann hierdurch das Risiko des Überschreitens von thermischen Betriebsgrenzen der Batterie reduziert werden, aber dieses Verfahren ist nachteilig, um möglichst flexibel auf fahrzeugseitige Leistungsanforderungen zu reagieren.

Es ist somit eine Aufgabe der Erfindung, ein verbessertes Betriebsverfahren für einen Energiespeicher für elektrische Energie bereitzustellen, mit dem Nachteile herkömmlicher Betriebsverfahren vermieden werden können. Die Aufgabe der Erfindung ist es insbesondere, ein Verfahren zur temperaturabhängigen Strombegrenzung eines solchen Energiespeichers bereitzustellen, mit dem ein dauerhaftes Überschreiten der thermischen Betriebsgrenzen verhindert und gleichzeitig flexibel auf fahrzeugseitige Leistungsanforderungen reagiert werden kann. Eine weitere Aufgabe ist es, eine Vorrichtung zur temperaturabhängigen Strombegrenzung des Energiespeichers bereitzustellen, mit der Nachteile herkömmlicher Vorrichtungen vermieden werden können.

Diese Aufgaben werden durch Vorrichtungen und Verfahren mit den Merkmalen der unabhängigen Ansprüche gelöst. Vorteilhafte Ausführungsformen und Anwendungen der Erfindung sind Gegenstand der abhängigen Ansprüche und werden in der folgenden Beschreibung unter teilweiser Bezugnahme auf die Figuren näher erläutert.

Gemäß einem ersten Gesichtspunkt der Erfindung werden die genannten Aufgaben durch ein Verfahren zur temperaturabhängigen Strombegrenzung eines Energiespeichers für elektrische Energie gelöst. Gemäß dem erfindungsgemäßen Verfahren erfolgt eine Anpassung eines maximal zulässigen Lade- und/oder Entladestroms des Energiespeichers in Abhängigkeit von einer Temperatur des Energiespeichers, wobei die folgenden Schritte ausgeführt werden: Ermitteln mehrerer zeitlich aufeinanderfolgender Energiespeichertemperaturwerte während eines aktuellen Zeitintervalls, d. h. die Energiespeichertemperaturwerte werden an unterschiedlichen, aufeinanderfolgenden Zeitpunkten im jeweils aktuellen Zeitintervall gemessen; Bestimmen eines aktuellen Mittelwerts der Energiespeichertemperatur während des aktuellen Zeitintervalls aus den ermittelten Energiespeichertemperaturwerten; Vergleichen des bestimmten aktuellen Mittelwerts mit einem vorbestimmten Temperatur-Sollwert; und Einschränken des maximal zulässigen Lade- und/oder Entladestroms des Energiespeichers, wenn der bestimmte aktuelle Mittelwert größer als der Temperatur-Sollwert ist.

Die Erfindung umfasst also die allgemeine technische Lehre, die oberen Grenzen für die Lade- und/oder Entladeströme in Abhängigkeit von einer Abweichung bzw. Differenz eines Mittelwerts der Energiespeichertemperatur von einem vorgegebenen Sollwert zu bestimmen. Die temperaturabhängige Anpassung der maximal zulässigen Lade- und/oder Entladeströme bietet im Vergleich zu starren Grenzwerten die Möglichkeit, die maximal zulässigen Lade- und/oder Entladeströme breiter auszulegen und nur bei Bedarf, d. h. falls die mittlere Energiespeichertemperatur einen kritischen Temperaturschwellenwert überschreitet, temporär einzuschränken. Erfindungsgemäß wird dabei nicht nur ein einzelner momentan gemessener Temperaturwert des Energiespeichers mit dem kritischen Temperaturschwellenwert verglichen, sondern ein Temperaturmittelwert des Energiespeichers, der den vorangegangenen Temperaturverlauf im Energiespeicher über ein definiertes Zeitintervall abbildet. Dies bietet den Vorzug, dass kurzzeitig höhere Temperaturen im Energiespeicher zulässig sind, die die Lebensdauer bekanntermaßen stärker absenken, wenn zu einem anderen Zeitpunkt niedrigere Temperaturen im Energiespeicher vorlagen. Dadurch können die zulässigen Stromgrenzen breiter ausgelegt und die Leistungsfähigkeit des Energiespeichers erhöht werden, ohne eine im Vergleich zum Stand der Technik beschleunigte Alterung in Kauf nehmen zu müssen.

Der Begriff Energiespeicher für elektrische Energie", nachfolgend auch kurz als Energiespeicher bezeichnet, umfasst insbesondere Traktionsbatterien bzw. Hochvoltbatterien für Mildhybrid-, Hybrid- oder Elektrofahrzeuge. Unter einer Traktionsbatterie bzw. einer Hochvoltbatterie wird eine Batterie bzw. ein Batteriepack aus vorzugsweise Li-Ionen-Zellen zur Bereitstellung von elektrischer Energie für einen reinen elektromotorischen Antrieb oder zumindest einen elektromotorisch unterstützen Antrieb eines als Mildhybrid-, Hybrid- oder Elektrofahrzeug ausgeführten Kraftfahrzeugs verstanden.

Der Begriff "Lebensdauer" bezeichnet die Zeit von der ersten Inbetriebnahme des Energiespeichers, bei der dieser einen Alterungszustand (engl. State of Health, SoH) von 100% und somit seine volle Leistungsfähigkeit aufweist, bis zum Erreichen eines Endalterungszustands, der mit 0% angeben wird. 0% bedeutet in diesem Zusammenhang, dass der Energiespeicher gerade noch eine vorgegebene Mindestleistungsfähigkeit aufweist, und nicht, dass er überhaupt nicht mehr funktionsfähig ist.

Für Energiespeicher, die eine Mehrzahl von in Reihe und/oder parallel geschalteten Einzelzellen, z. B. Lithium-Ionen-Zellen umfassen, geben die Energiespeichertemperaturwerte ein Maß für die in den Zellen herrschenden Temperaturwerte an, die mit aus dem Stand der Technik an sich bekannten Messvorrichtungen bestimmt werden können.

Vorzugsweise wird der maximal zulässige Lade- und/oder Entladestrom mit zunehmender Abweichung des Mittelwerts von dem vorbestimmten Temperatur-Sollwert stärker eingeschränkt, so dass die Energiespeichertemperatur nach Überschreiten des Temperatur-Sollwerts möglichst schnell wieder auf diesen oder unter diesen abgesenkt wird.

Erfindungsgemäß wird der aktuelle Mittelwert der Energiespeichertemperatur als gewichteter Mittelwert bestimmt, wobei hohe Energiespeichertemperaturen stärker als niedrige Energiespeichertemperaturen gewichtet
werden. Damit kann automatisch berücksichtigt und kompensiert werden, dass höhere Energiespeichertemperaturen die Lebensdauer des Energiespeichers stärker absenken als tiefere Temperaturen, wodurch eine bessere Lebensdaueroptimierung ermöglicht wird.

Bei einer vorteilhaften Variante dieser Ausgestaltungsform wird eine Lookup-Tabelle bereitgestellt, anhand der jedem Energiespeichertemperaturwert ein Gewichtungsfaktor zugeordnet werden kann. Ferner werden gemäß dieser Variante zur Bestimmung des gewichteten Mittelwerts die Energiespeichertemperaturwerte des aktuellen Zeitintervalls mit ihrem zugeordneten Gewichtungsfaktor multipliziert und anschließend addiert. Die resultierende Summe wird anschließend durch die Summe der zugeordneten Gewichtungsfaktoren geteilt.

Der aktuelle Mittelwert der Energiespeichertemperatur und damit die Anpassung des maximal zulässigen Lade- und/oder Entladestroms des Energiespeichers werden vorzugsweise fortlaufend bzw. regelmäßig bestimmt. Wenn nach einer erfolgten Einschränkung des maximal zulässigen Lade- und/oder Entladestroms ein nachfolgend bestimmter nunmehr aktueller Mittelwert nicht mehr größer als der Temperatur-Sollwert ist, wird die Einschränkung des maximal zulässigen Lade- und/oder Entladestroms rückgängig gemacht bzw. aufgehoben.

Gemäß einer Variante der Erfindung werden hierbei die zur fortlaufenden Bildung des Mittelwerts verwendeten Energiespeichertemperaturwerte T1 bis Tn in eine Speichereinrichtung eingeschrieben und aus einer bestimmten Zahl der zuletzt gespeicherten Energiespeichertemperaturwerte T1 bis Tn fortlaufend ein gleitender Mittelwert gebildet, wobei jeweils der (die) in der Speichereinrichtung gespeicherte(n) älteste(n) Energiespeichertemperaturwert(e) durch den (die) neuesten ersetzt werden. Ausgehend vom aktuellen Zeitpunkt werden somit jeweils die n zuletzt gemessenen Energiespeichertemperaturwerte zur Bildung des gleitenden und sich somit in der Regel über die Zeit verändernden Mittelwerts verwendet, wodurch eine zuverlässig fortlaufende Bestimmung des vorangegangenen durchschnittliche Temperaturverlaufs im Energiespeichers ermöglicht wird.

Der maximal zulässige Ladestrom ist durch eine obere Grenze des zulässigen Stroms bestimmt, mit welchem der Energiespeicher für eine Dauer eines neu beginnenden Zeitintervalls vorbestimmter Länge geladen werden kann. In vergleichbarer Weise ist der maximal zulässige Entladestrom durch eine obere Grenze des Stroms bestimmt, welcher dem Energiespeicher für die Dauer eines neu beginnenden Zeitintervalls vorbestimmter Länge entnommen werden kann. Die Anpassung des zulässigen Lade- und/oder Entladestroms des Energiespeichers erfolgt durch Anpassung dieser oberen Grenzen.

Im Rahmen der Erfindung besteht ferner die Möglichkeit, dass die maximal zulässigen Lade- und Entladeströme des Energiespeichers jeweils in Bezug auf mindestens zwei Zeitintervalle unterschiedlicher Länge festgelegt werden. Beispielsweise kann eine Länge eines ersten Zeitintervalls im einstelligen und eine Länge eines zweiten Zeitintervalls im zweistelligen Sekundenbereich liegen. Diese Festlegungen der Stromgrenzen für das Laden und Entladen des Energiespeichers für unterschiedliche Zeithorizonte bietet den Vorteil, dass z. B. für kurze Leistungsanforderungen, die z. B. innerhalb des ersten Zeitintervalls liegen, höhere zulässige Lade- und/oder Ladeströme festgelegt werden können als für längere Leistungsanforderungen. Lediglich beispielhaft können beispielsweise maximal zulässige Lade- und Entladeströme des Energiespeichers jeweils für Zeitintervalle von 2, 10 und 30 Sekunden festgelegt werden. Ein maximal zulässiger Ladestrom von 100A für das Zeitintervall von 2 Sekunden gibt dann beispielsweise an, dass für die Dauer von 2 Sekunden höchstens ein maximaler Strom von 100A entnommen werden darf.

Gemäß einer weiteren Variante der Erfindung umfasst das Verfahren ferner die Schritte: Bestimmen einer Vorbelastung der Batterie auf Basis von gespeicherten Betriebsdaten, die die Lade- und/oder Entladeströme des Energiespeichers in einem aktuellen und/oder vergangenem Zeitintervall angeben; und Anpassen der maximal zulässigen Lade- und/oder Entladeströme des Energiespeichers in Abhängigkeit von der bestimmten Vorbelastung des Energiespeichers. Diese Variante basiert auf der Erkenntnis, dass die in einem Zeitintervall vor dem aktuellen Berechnungszeitpunkt gestellte Leistungsanforderung und der daraus resultierende Batteriestrom erheblich die zulässigen Stromgrenzen für Lade- und Entladevorgänge für zukünftige Zeitintervalle beeinflussen können. Vorteilhaft ist hierbei, wenn die Anpassung der maximal zulässigen Lade- und/oder Entladeströme des Energiespeichers in Abhängigkeit von der Vorbelastung des Energiespeichers ebenfalls fortlaufend erfolgt.

Gemäß dieser Variante erfolgt neben einer temperaturabhängigen Anpassung der maximal zulässigen Lade- und/oder Entladeströme des Energiespeichers somit ferner eine Anpassung auf Basis der Vorbelastung des Energiespeichers, so dass die Stromgrenzen für das Laden und Entladen des Energiespeichers, insbesondere für die zukünftige Lade- und/oder Entladezeitintervalle, in einem zweistufigen Prozess angepasst werden.

Ferner ist es hierbei vorteilhaft, wenn eine erste Anpassung der jeweils bislang gültigen maximal zulässigen Lade- und/oder Entladeströme des Energiespeichers in Abhängigkeit von der bestimmten Vorbelastung des Energiespeichers erfolgt und anschließend eine zweite Anpassung in Abhängigkeit von dem Vergleich des bestimmten aktuellen Mittelwerts der Energiespeichertemperatur mit dem vorbestimmten Temperatur-Sollwert erfolgt. Die temperaturabhängige Anpassung der maximal zulässigen Lade- und/oder Entladeströme basierend auf dem Temperaturmittelwert dient somit als zusätzliche Korrektur der vorhergesagten zulässigen Lade- und/oder Entladeströme auf Basis der ersten Anpassung.

Schließlich besteht im Rahmen der Erfindung die Möglichkeit, dass die von einer Steuervorrichtung des Energiespeichers gemäß den vorstehend beschriebenen Aspekten bestimmten und ggf. angepassten Werte der maximal zulässigen Lade- und/oder Entladeströme fortlaufend an eine Fahrzeugsteuerung zur Steuerung der Antriebsstrangkomponenten des Kraftfahrzeugs übermittelt werden, wobei die Fahrzeugsteuerung eingerichtet ist, unter Einhaltung der empfangenen Werte der maximal zulässigen Lade- und/oder Entladeströme eine von dem Energiespeicher mit elektrischer Energie versorgte elektrische Maschine, insbesondere deren Inverter, als Stellglied anzusteuern.

Gemäß einem weiteren Gesichtspunkt der Erfindung wird eine Vorrichtung zur Steuerung und/oder Regelung einer Temperatur eines Energiespeichers für elektrische Energie bereitgestellt, die ausgeführt ist, das Verfahren wie hierin offenbart durchzuführen.

Die Erfindung betrifft ferner ein Kraftfahrzeug, vorzugsweise ein Nutzfahrzeug, mit einer solchen Vorrichtung.

Die zuvor beschriebenen bevorzugten Ausführungsformen und Merkmale der Erfindung sind beliebig miteinander kombinierbar. Weitere Einzelheiten und Vorteile der Erfindung werden im Folgenden unter Bezug auf die beigefügten Zeichnungen beschrieben. Es zeigen:
- Figur 1: ein Ablaufdiagramm zur Illustration einer Ausführungsform des erfindungsgemäßen Verfahrens; und
- Figur 2: schematisch die Berechnung angepasster maximal zulässiger Lade- und Entladeströme in Abhängigkeit von der Batterievorbelastung und dem Temperaturmittelwert des Energiespeichers gemäß einer Ausführungsform der Erfindung.

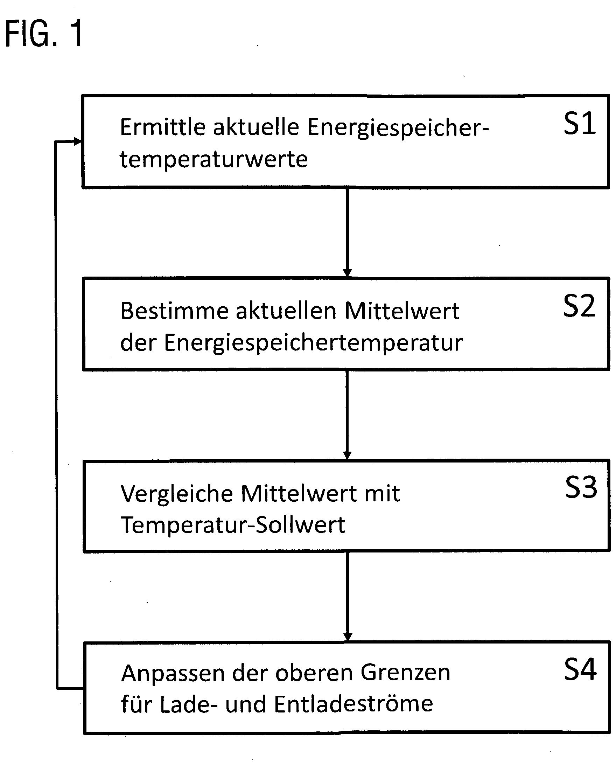

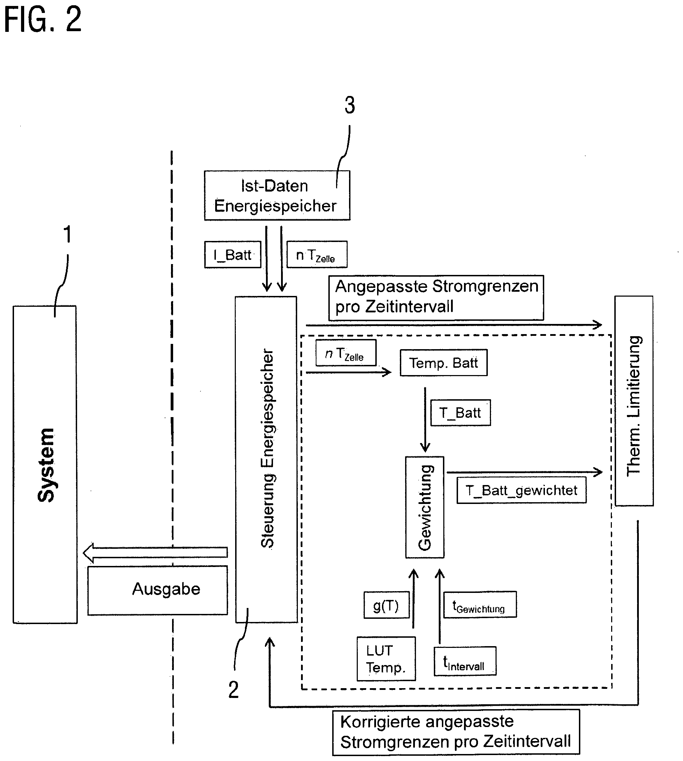

Figur 1 illustriert ein Ablaufdiagramm zur Illustration der Anpassung maximal zulässiger Lade- und Entladeströme in Abhängigkeit von dem Temperaturmittelwert des Energiespeichers. Im Rahmen der Beschreibung der Figur 1 wird nachfolgend ferner auf die Figur 2 verwiesen, um Details der einzelnen Verfahrensschritte zu illustrieren.

In Schritt S1 werden im Betrieb des Energiespeichers fortlaufend aktuelle Temperaturwerte des Energiespeichers bestimmt und in einer Speichereinrichtung 3 gespeichert. Bei dem Energiespeicher handelt es sich vorliegend um eine Traktionsbatterie (Hochvoltbatterie) eines Nutzfahrzeugs, die in an sich bekannter Weise ein Batteriepack (nicht dargestellt) aus einer Mehrzahl von Einzelzellen umfasst. Die Batterie umfasst ferner eine Steuereinheit, die in Figur 2 mit dem Bezugszeichen 2 gekennzeichnet ist. Die Batterie weist in an sich bekannter Weise Temperatursensoren zur Bestimmung der aktuellen Temperatur T_{Zelle} der Einzelzellen auf, wobei zeitlich fortlaufend an aufeinanderfolgenden Messzeitpunkten tᵢ Temperaturmesswerte der Einzelzellen T_{Zelle} bestimmt und in einer Speichereinrichtung 3 zur Speicherung von Ist-Daten der Batterie gespeichert werden. Anstatt Temperaturmesswerte der Einzelzellen T_{Zelle} können je nach Ausführung der Temperaturmessvorrichtung der Batterie auch nur Temperaturmesswerte für einige oder nur für eine Zelle bestimmt werden.

In Schritt S2 wird aus den Temperaturmesswerten der Batterie in Form der Temperaturmesswerte der Einzelzellen T_{Zelle} fortlaufend ein aktueller Mittelwert der Batterietemperatur bestimmt, der den vorangegangenen Temperaturverlauf im Energiespeicher über ein definiertes Zeitintervall abbildet. Die einzelnen Schritte zur Berechnung des Mittelwerts sind in Figur 2 innerhalb des gestrichelten Kastens dargestellt.

Hierzu liest die Steuereinheit 2 aus der Speichereinrichtung 3 zunächst diejenigen n Temperaturmesswerte für jede der Einzelzellen T_{Zelle} aus, die während eines fest vorgegebenen Zeitintervalls an den Messzeitpunkten t₁ bis tₙ bis zum aktuellen Berechnungszeitpunkt (aktuelles Zeitintervall) gemessen wurden. In einem nachfolgenden Verarbeitungsschritt (in Figur 2 bezeichnet mit "Temp. Batt") wird aus den Temperaturmesswerten der Einzelzellen T_{Zelle}, die am gleichen Messzeitpunkt gemessen wurden, ein aggregrierter Temperaturmesswert berechnet, der als Maß für die Batterietemperatur zum jeweiligen Messzeitpunkt innerhalb des aktuellen Zeitintervalls dient. Hierfür können die Temperaturmesswerte der Einzelzellen T_{Zelle} gemittelt werden, typischerweise werden hierfür jedoch komplexere Berechnungsverfahren eingesetzt, die an sich aus dem Stand der Technik bekannt sind. Insgesamt ergeben sich somit *n* aggregrierte Temperaturmesswerte T1 bis Tn (in Figur 2 mit "T_Batt" bezeichnet), entsprechend den n Messzeitpunkte tᵢ, i = 1 bis n, im aktuellen Zeitintervall. Diese n Temperaturmesswerte T1 bis Tn werden im Rahmen der nachfolgenden Berechnung eines gewichteten Mittelwerts (in Figur 2 mit "Gewichtung" bezeichnet) weiterverarbeitet.

Die Energiespeichertemperatur im aktuellen Zeitintervall wird als gewichteter Mittelwert bestimmt, wobei hohe Energiespeichertemperaturen stärker als niedrige Energiespeichertemperaturen gewichtet werden. Hierzu wird eine Lookup-Tabelle (in Figur 2 mit "LUT Temp." bezeichnet) bereitgestellt, anhand der jedem Energiespeichertemperaturwert T1 bis Tn ein Gewichtungsfaktor zugeordnet werden kann.

Für eine einfache Gewichtung wird beispielsweise der Wert 1 für Temperaturen gesetzt, die sich innerhalb eines vorgegebenen mittleren Temperaturbereichs befinden, bei höheren Temperaturen der Batterie kann dieser Wert höher sein, bei sehr niedrigen Temperaturen kleiner als 1. Dadurch wird kompensiert, dass eine höhere Temperatur die Lebensdauer schneller absenkt als eine niedrige Temperatur.

Es wird somit für jeden Energiespeichertemperaturwert T1 bis Tn der entsprechende Gewichtungsfaktor g(T) anhand der Lookup-Tabelle ermittelt. Anschließend werden zur Bestimmung des gewichteten Mittelwerts die Energiespeichertemperaturwerte T1 bis Tn des aktuellen Zeitintervalls mit ihrem zugeordneten Gewichtungsfaktor multipliziert und dann addiert. Schließlich wird die Summe der zugeordneten Gewichtungsfaktoren t_{Gewichtung} bestimmt. Mit anderen Worten wird, um den gewichteten Durchschnitt der Temperatur über ein festes Zeitintervall (t_intervall) zu bestimmen, noch t_{Gewichtung} berechnet, bei dem auch die Zeit mit den aktuellen Gewichtungsfaktoren verrechnet wird.

Die Summe der gewichteten Temperaturwerte T1 bis Tn wird anschließend durch die Summe der zugeordneten Gewichtungsfaktoren t_{Gewichtung}, d. h. die gewichtete Zeit, geteilt. Als Ergebnis ergibt sich der gewichtete Mittelwert (in Figur 2 mit "T_Batt_gewichtet" bezeichnet) der Batterie im aktuellen Zeitintervall.

In Schritt S3 wird der berechnete aktuelle gewichtete Mittelwert dann mit einem vorgegebenen Temperatur-Sollwert verglichen, der nicht überschritten werden soll.

In Schritt S4 erfolgt dann ggf. eine Anpassung der maximal zulässigen Lade- und Entladeströme. Wenn der berechnete aktuelle gewichtete Mittelwert kleiner gleich dem vorgegebenen Temperatur-Sollwert ist, findet keine temperaturbedingte Anpassung der Stromgrenzen statt. Wenn der aktuelle gewichtete Mittelwert größer als der Temperatur-Sollwert ist, werden die oberen Grenzen für die Lade- und Entladeströme korrigiert und so weit heruntergenommen, dass keine weitere Erhöhung der Zelltemperatur stattfindet. Eine Reduzierung der Lade- und Entladeströme auf 0 findet vorliegend nicht statt. Um sanftere Übergänge zu erreichen, können eine untere und eine obere maximale Solltemperatur definiert werden, zwischen denen die Reduktion der oberen Grenzen für die Lade- und Entladeströme linear zunimmt.

Vorstehend wurde bereits erwähnt, dass der gewichtete Temperaturmittelwert fortlaufend als gleitender Mittelwert gebildet wird. Nach Schritt S4 beginnt der Regelkreis somit von Neuem. Das neue aktuelle Zeitintervall umfasst jetzt die Messzeitpunkte tᵢ, i = 2 bis n+1. Die neu gemessenen Temperaturmesswerte der Einzelzellen T_{Zelle}zum Zeitpunkt tₙ+₁ ersetzen die in der Speichereinrichtung gespeicherten ältesten Temperaturmesswerte der Einzelzellen T_{Zelle}. Ausgehend vom aktuellen Zeitpunkt tₙ+₁ werden somit in Schritt S2 wiederum jeweils die n zuletzt gemessenen Energiespeichertemperaturwerte T₂ bis Tₙ+₁ zur Bildung des gleitenden und sich somit in der Regel über die Zeit verändernden Mittelwerts verwendet, wodurch zuverlässig fortlaufende Bestimmung des vorangegangenen durchschnittlichen Temperaturverlaufs im Energiespeicher ermöglicht wird.

Gemäß der vorliegenden Ausführungsvariante erfolgt neben der temperaturabhängigen Anpassung der maximal zulässigen Lade- und/oder Entladeströme des Energiespeichers zusätzlich eine Anpassung auf Basis der Vorbelastung des Energiespeichers und/oder auf Basis einer fahrzeugseitigen Leistungsanforderung.

Wie in Figur 2 schematisch illustriert, ist die Steuereinheit 2 hierzu eingerichtet, eine Vorbelastung der Batterie auf Basis von gespeicherten Betriebsdaten, die die Lade- und/oder Entladeströme des Energiespeichers in einem aktuellen und/oder vergangenen Zeitintervall angeben (in Figur 2 mit "I_Batt" bezeichnet), zu bestimmen. Mit anderen Worten prädiziert die Steuereinheit 2 in Abhängigkeit von der bisherigen Strombelastung der Batterie die zulässigen Obergrenzen für den Lade- und Entladestrom für neu beginnende Zeitintervalle vorbestimmter Länge, in Figur 2 mit "angepasste Stromgrenzen pro Zeitintervall" bezeichnet. Diese Obergrenzen geben die maximal zulässigen Lade- und Entladeströme des Energiespeichers jeweils für die Zeitintervalle von beispielsweise 2, 10 und 30 Sekunden an. Diese Grenzen berücksichtigen beispielsweise die maximalen, lebensdauerangepassten Stromgrenzen durch die Zelle sowie die Einhaltung der oberen und unteren Spannungsgrenze. Diese Werte berücksichtigen dahingehend eine Vorbelastung, als dass die lebensdauerangepassten Stromgrenzen der Zelle auch die zeitliche Länge einer Strombelastung beinhalten, die nicht überschritten werden darf. Hierzu wird die Vorbelastung durch Stromentnahme oder -abgabe erfasst und die aktuellen und zukünftigen Stromgrenzen entsprechend herabgesetzt. Wenn beispielsweise ein hoher Ladestrom für insgesamt 10s anliegen darf und zum Zeitpunkt der aktuellen Stromgrenzenberechnung bereits über 5s angelegen hat, können die Grenzen insoweit angepasst werden, als dass dieser Ladestrom nur noch für weitere 5s möglich ist. Für weiter in der Zukunft liegende Stromgrenzen werden diese soweit reduziert, als dass unter Berücksichtigung der Vorbelastung keine Stromgrenze in keinem Zeitintervall güber- oder unterschritten wird. Ebenso führt die Vorbelastung zu sich ändernden Innenwiderständen, was die Stromgrenzen zur Einhaltung der Spannungsgrenzen beeinflusst. Ein höherer Innenwiderstand durch eine längerfristige Stromentnahme führt zu einem höheren Innenwiderstand in Entladerichtung. Dies führt wiederum zu einem geringeren Strom, der entnommen werden kann, ohne die untere Spannungsgrenze zu unterschreiten.

Auf diese zunächst temperaturunabhängige Anpassung der Stromgrenzen folgt dann die temperaturabhängige zusätzliche Anpassung auf Basis des gewichteten Mittelwerts der Batterie-Temperatur, wie vorstehend beschrieben. Dies ist in Figur 2 durch den Berechnungsschritt "therm. Limitierung" dargestellt. Die thermische Limitierung aufgrund des aktuellen gewichteten Mittelwerts der Batterietemperatur führt somit zu korrigierten Werten für die Stromgrenzen ("korrigierte angepasste Stromgrenzen pro Zeitintervall" in Figur 2), falls der aktuelle gewichtete Mittelwert größer als der Temperatur-Sollwert ist. Die korrigierten Werte geben dann ggf. angepasste Obergrenzen für die maximal zulässigen Lade- und Entladeströme des Energiespeichers jeweils für die Zeitintervalle von z. B. 2, 10 und 30 Sekunden an.

Die von der Steuereinheit 2 des Energiespeichers gemäß den vorstehend beschriebenen Aspekten bestimmten und ggf. angepassten Werte der maximal zulässigen Lade- und/oder Entladeströme werden dann fortlaufend an die Fahrzeugsteuerung, die die Antriebsstrangkomponenten des Kraftfahrzeugs ansteuert, übermittelt, dargestellt in Figur 2 durch "Ausgabe". Hierbei ist die Fahrzeugsteuerung 1 eingerichtet, unter Einhaltung der empfangenen Werte der maximal zulässigen Lade- und/oder Entladeströme eine von dem Energiespeicher mit elektrischer Energie versorgte elektrische Maschine, insbesondere deren Inverter, als Stellglied anzusteuern.

Obwohl die Erfindung unter Bezugnahme auf bestimmte Ausführungsbeispiele beschrieben worden ist, ist es für einen Fachmann ersichtlich, dass verschiedene Änderungen ausgeführt werden können und Äquivalente als Ersatz verwendet werden können, ohne den Bereich der Erfindung zu verlassen. Zusätzlich können viele Modifikationen ausgeführt werden, ohne den zugehörigen Bereich zu verlassen. Folglich soll die Erfindung nicht auf die offenbarten Ausführungsbeispiele begrenzt sein, sondern soll alle Ausführungsbeispiele umfassen, die in den Bereich der beigefügten Patentansprüche fallen.

### Bezugszeichenliste

- 1: Fahrzeugsteuerung
- 2: Steuereinheit der Batterie
- 3: Speichereinrichtung

## Patentansprüche

1. Verfahren zur temperaturabhängigen Strombegrenzung eines Energiespeichers für elektrische Energie, aufweisend
eine Anpassung eines maximal zulässigen Lade- und/oder Entladestroms des Energiespeichers in Abhängigkeit von einer Temperatur des Energiespeichers, wobei die Anpassung die folgenden Schritte umfasst:
Ermitteln mehrerer zeitlich aufeinanderfolgender Energiespeichertemperaturwerte während eines aktuellen Zeitintervalls (S1);
Bestimmen eines aktuellen Mittelwerts der Energiespeichertemperatur während des aktuellen Zeitintervalls aus den ermittelten Energiespeichertemperaturwerten (S2);
Vergleichen des bestimmten aktuellen Mittelwerts mit einem vorbestimmten Temperatur-Sollwert (S3); und
Einschränken des maximal zulässigen Lade- und/oder Entladestroms des Energiespeichers, wenn der bestimmte aktuelle Mittelwert größer als der Temperatur-Sollwert ist (S4)
**dadurch gekennzeichnet, dass** der aktuelle Mittelwert der Energiespeichertemperatur als gewichteter Mittelwert bestimmt wird, wobei hohe Energiespeichertemperaturen stärker als niedrige Energiespeichertemperaturen gewichtet werden.

2. Verfahren nach Anspruch 1, **dadurch gekennzeichnet,**
a) **dass** eine Lookup-Tabelle bereitgestellt wird, anhand der jedem Energiespeichertemperaturwert ein Gewichtungsfaktor zugeordnet werden kann; und
b) **dass** zur Bestimmung des gewichteten Mittelwerts die Energiespeichertemperaturwerte des aktuellen Zeitintervalls mit ihrem zugeordneten Gewichtungsfaktor multipliziert und anschließend addiert werden und die resultierende Summe durch die Summe der zugeordneten Gewichtungsfaktoren geteilt wird.

3. Verfahren nach einem der vorhergehenden Ansprüche, **dadurch gekennzeichnet, dass** der aktuelle Mittelwert der Energiespeichertemperatur und damit die Anpassung des maximal zulässigen Lade- und/oder Entladestroms des Energiespeichers fortlaufend bestimmt werden, indem die zur Bildung des Mittelwerts verwendeten Energiespeichertemperaturwerte in eine Speichereinrichtung eingeschrieben werden und aus einer bestimmten Zahl der zuletzt gespeicherten Energiespeichertemperaturwerte fortlaufend ein gleitender Mittelwert gebildet wird, wobei jeweils der in der Speichereinrichtung gespeicherte älteste Energiespeichertemperaturwert durch den neuesten ersetzt wird.

4. Verfahren nach einem der vorhergehenden Ansprüche, **dadurch gekennzeichnet,**
a) **dass** der maximal zulässige Ladestrom durch eine obere Grenze des zulässigen Stroms bestimmt ist, mit welchem der Energiespeicher für eine Dauer eines neu beginnenden Zeitintervalls vorbestimmter Länge geladen werden kann; und
b) **dass** der maximal zulässige Entladestrom durch eine obere Grenze des Stroms bestimmt ist, welcher dem Energiespeicher für die Dauer eines neu beginnenden Zeitintervalls vorbestimmter Länge entnommen werden kann, wobei die Anpassung des zulässigen Lade- und/oder Entladestroms des Energiespeichers durch Anpassung dieser oberen Grenzen erfolgt.

5. Verfahren nach Anspruch 4, **dadurch gekennzeichnet, dass** die maximal zulässigen Lade- und Entladeströme des Energiespeichers jeweils in Bezug auf mindestens zwei Zeitintervalle unterschiedlicher Länge festgelegt werden, wobei eine Länge eines ersten Zeitintervalls vorzugsweise im einstelligen und eine Länge eines zweiten Zeitintervalls vorzugsweise im zweistelligen Sekundenbereich liegt.

6. Verfahren nach einem der vorhergehenden Ansprüche, **gekennzeichnet durch** die Schritte:
a) Bestimmen einer Vorbelastung der Batterie auf Basis von gespeicherten Betriebsdaten, die die Lade- und/oder Entladeströme des Energiespeichers in einem aktuellen und/oder vergangenem Zeitintervall angeben; und
b) Anpassen der maximal zulässigen Lade- und/oder Entladeströme des Energiespeichers in Abhängigkeit von der bestimmten Vorbelastung des Energiespeichers.

7. Verfahren nach Anspruch 6, **dadurch gekennzeichnet, dass** die Anpassung der maximal zulässigen Lade- und/oder Entladeströme des Energiespeichers in Abhängigkeit von der bestimmten Vorbelastung des Energiespeichers fortlaufend erfolgt, wobei eine erste Anpassung der jeweils bislang gültigen maximal zulässigen Lade- und/oder Entladeströme des Energiespeichers in Abhängigkeit von der bestimmten Vorbelastung des Energiespeichers erfolgt und anschließend eine zweite Anpassung in Abhängigkeit von dem Vergleich des bestimmten aktuellen Mittelwerts der Energiespeichertemperatur mit dem vorbestimmten Temperatur-Sollwert erfolgt.

8. Verfahren nach einem der vorhergehenden Ansprüche, **dadurch gekennzeichnet, dass** angepasste Werte der maximal zulässigen Lade- und/oder Entladeströme fortlaufend von einer Steuervorrichtung (2) des Energiespeichers an eine Fahrzeugsteuerung (1) zur Steuerung der Antriebsstrangkomponenten des Kraftfahrzeugs übermittelt werden, wobei die Fahrzeugsteuerung (1) eingerichtet ist, unter Einhaltung der empfangenen Werte der maximal zulässigen Lade- und/oder Entladeströme eine von dem Energiespeicher mit elektrischer Energie versorgte elektrische Maschine anzusteuern.

9. Vorrichtung (2) zur temperaturabhängigen Strombegrenzung eines Energiespeichers für elektrische Energie, die ausgeführt ist, das Verfahren nach einem der Ansprüche 1 bis 8 durchzuführen.

10. Fahrzeug, insbesondere Nutzfahrzeug, mit einer Vorrichtung (2) nach Anspruch 9.

## Claims

1. Method for limiting the current in a temperature-dependent manner of an energy storage device for electrical energy, comprising
adjusting a maximum permissible charging and/or discharging current of the energy storage device in dependence upon a temperature of the energy storage device, wherein the adjustment comprises the following steps:
determining multiple temperature values of the energy storage device that follow one another chronologically during a prevailing time interval (S1) ;
determining a prevailing mean temperature value of the energy storage device from the determined temperature values of the energy storage device during a prevailing time interval (S2);
comparing the determined prevailing mean value with a predetermined desired temperature value (S3); and
limiting the maximum permissible charging and/or discharging current of the energy storage device if the determined prevailing mean value is greater than the desired temperature value (S4)
**characterized in that** the prevailing mean temperature value of the energy storage device is determined as a weighted mean value, wherein high temperatures of the energy storage device are weighted more heavily than low temperatures of the energy storage device.

2. Method according to Claim 1, **characterized in that,**
(a) a lookup table is provided and each temperature value of the energy storage device can be allocated a weighting factor with reference to said lookup table; and
(b) so as to determine the weighted mean value the temperature values of the energy storage device of the prevailing time interval are multiplied by their allocated weighting factor and subsequently summed and the resulting sum is divided by the sum of the allocated weighting factors.

3. Method according to either one of the preceding claims, **characterized in that,** the prevailing mean temperature value of the energy storage device and thereby the adjustment of the maximum, permissible charging and/or discharging current of the energy storage device are continuously determined, **in that** the temperature values of the energy storage device that are used so as to form the mean value are recorded in a storage device and a moving mean value is continuously formed from a specific number of the most recently stored temperature values of the energy storage device, wherein in each case the oldest temperature value of the energy storage device stored in the storage device is replaced by the newest temperature value of the energy storage device.

4. Method according to any one of the preceding claims, **characterized in that,**
(a) the maximum permissible charging current is determined by means of an upper threshold of the permissible current, with which the energy storage device can be charged for a duration of a newly beginning time interval of a predetermined length; and
(b) the maximum permissible discharging current is determined by means of an upper threshold of the current that can be drawn off for the duration of a newly beginning time interval of a predetermined length, wherein the permissible charging and/or discharging current of the energy storage device is performed by means of adjusting this upper threshold.

5. Method according to Claim 4, **characterized in that,** the maximum permissible charging and discharging currents of the energy storage device in each case are set in relation to at least two time intervals of different lengths, wherein a length of a first time interval is preferably in the single digit second range and a length of a second time interval is preferably in the double digit second range.

6. Method according to any one of the preceding claims, **characterized by means of** the steps:
(a) determining a previous loading of the battery on the basis of stored operating data that provide the charging and/or discharging currents of the energy storage device in a prevailing and/or previous time interval; and
(b) adjusting the maximum permissible charging and/or discharging currents of the energy storage device in dependence upon the determined previous loading of the energy storage device.

7. Method according to Claim 6, **characterized in that,** the maximum permissible charging and/or discharging currents of the energy storage device are continuously adjusted in dependence upon the determined previous loading of the energy storage device, wherein a first adjustment of the respective hitherto valid maximum permissible charging and/or discharging currents of the energy storage device is performed in dependence upon the determined previous loading of the energy storage device and subsequently a second adjustment is performed in dependence upon the comparison of the determined prevailing mean values of the energy storage device temperature with the predetermined desired temperature value.

8. Method according to any one of the preceding claims, **characterized in that,** adjusted values of the maximum permissible charging and/or discharging currents are continuously transmitted by an open loop control device (2) of the energy storage device to a vehicle control unit (1) so as to control the drive train components of the motor vehicle, wherein the vehicle control unit (1) is configured so as to control an electrical machine that is supplied with electrical energy by the energy storage device in accordance with the received values of the maximum permissible charging and/or discharging currents.

9. Device (2) for limiting the current in a temperature-dependent manner of an energy storage device for electrical energy, said device being embodied so as to implement the method according to any one of the Claims 1 to 8.

10. Vehicle, in particular a commercial vehicle, having a device (2) according to Claim 9.

## Revendications

1. Procédé de limitation du courant en fonction de la température d'un accumulateur d'énergie pour de l'énergie électrique, comprenant
une adaptation d'un courant de charge et/ou de décharge maximale admissible de l'accumulateur d'énergie en fonction d'une température de l'accumulateur d'énergie, l'adaptation comprenant les étapes suivantes :
détermination de plusieurs valeurs de température de l'accumulateur d'énergie chronologiquement successives pendant un intervalle de temps actuel (S1) ;
définition d'une valeur moyenne actuelle de la température de l'accumulateur d'énergie pendant l'intervalle de temps actuel à partir des valeurs de température de l'accumulateur d'énergie déterminées (S2) ;
comparaison de la valeur moyenne actuelle définie avec une température de consigne prédéfinie (S3) ; et
limitation du courant de charge et/ou de décharge maximale admissible de l'accumulateur d'énergie lorsque la valeur moyenne actuelle définie est supérieure à la température de consigne (S4)
**caractérisé en ce que** la valeur moyenne actuelle de la température de l'accumulateur d'énergie est définie en tant que valeur moyenne pondérée, les températures élevées de l'accumulateur d'énergie ayant un poids supérieur à celui des températures basses de l'accumulateur d'énergie.

2. Procédé selon la revendication 1, **caractérisé en ce**
a) **qu'**un tableau de conversion est fourni, à l'aide duquel un facteur de pondération peut être associé à chaque valeur de la température de l'accumulateur d'énergie ; et
b) **que** pour définir la valeur moyenne pondérée, les valeurs de la température de l'accumulateur d'énergie de l'intervalle de temps actuel sont multipliées par le facteur de pondération qui leur est associé et sont ensuite additionnées, puis la somme résultante est divisée par la somme des facteurs de pondération associés.

3. Procédé selon l'une des revendications précédentes, **caractérisé en ce que** la valeur moyenne actuelle de la température de l'accumulateur d'énergie et ainsi l'adaptation du courant de charge et/ou de décharge maximale admissible de l'accumulateur d'énergie sont définies continuellement **en ce que** les valeurs de la température de l'accumulateur d'énergie utilisées pour former la valeur moyenne sont inscrites dans un dispositif de mémorisation et une valeur moyenne glissante est formée continuellement à partir d'un nombre défini des dernières valeurs de la température de l'accumulateur d'énergie mémorisées, la valeur de la température de l'accumulateur d'énergie la plus ancienne mémorisée dans le dispositif de mémorisation étant respectivement remplacée par la plus récente.

4. Procédé selon l'une des revendications précédentes, **caractérisé en ce**
a) **que** le courant de charge maximal admissible est défini par une limite supérieure du courant admissible avec laquelle l'accumulateur d'énergie peut être chargé pendant un intervalle de temps ayant une longueur prédéfinie nouvellement commencé ; et
b) **que** le courant de décharge maximal admissible est défini par une limite supérieure du courant qui peut être prélevé de l'accumulateur d'énergie pendant un intervalle de temps ayant une longueur prédéfinie nouvellement commencé, l'adaptation du courant de charge et/ou de décharge admissible de l'accumulateur d'énergie s'effectuant par adaptation de ces limites supérieures.

5. Procédé selon la revendication 4, **caractérisé en ce que** les courants de charge et de décharge maximaux admissibles de l'accumulateur d'énergie sont respectivement fixés en référence à au moins deux intervalles de temps de longueurs différentes, une longueur du premier intervalle de temps étant de préférence compris dans une plage de secondes à un chiffre et une longueur du deuxième intervalle de temps de préférence dans une plage de secondes à deux chiffres.

6. Procédé selon l'une des revendications précédentes, **caractérisé par** les étapes :
a) définition d'une précharge de la batterie sur la base de données opérationnelles mémorisées qui indiquent les courants de charge et/ou de décharge de l'accumulateur d'énergie dans un intervalle de temps actuel et/ou passé ; et
b) adaptation des courants de charge et/ou de décharge maximaux admissibles de l'accumulateur d'énergie en fonction de la précharge définie de l'accumulateur d'énergie.

7. Procédé selon la revendication 6, **caractérisé en ce que** l'adaptation des courants de charge et/ou de décharge maximaux admissibles de l'accumulateur d'énergie est effectuée continuellement en fonction de la précharge définie de l'accumulateur d'énergie, une première adaptation des courants de charge et/ou de décharge maximaux admissibles de l'accumulateur d'énergie respectivement valides jusqu'à présent étant effectuée en fonction de la précharge définie de l'accumulateur d'énergie et ensuite une deuxième adaptation étant effectuée en fonction de la comparaison de la valeur moyenne actuelle définie de la température de l'accumulateur d'énergie avec la température de consigne prédéfinie.

8. Procédé selon l'une des revendications précédentes, **caractérisé en ce que** les valeurs adaptées des courants de charge et/ou de décharge maximaux admissibles sont communiquées continuellement d'un arrangement de commande (2) de l'accumulateur d'énergie à une commande de véhicule (1) en vue de commande les composants de la chaîne cinématique du véhicule automobile, la commande de véhicule (1) étant conçue pour commander une machine électrique alimentée en énergie électrique par l'accumulateur d'énergie en respectant les valeurs reçues des courants de charge et/ou de décharge maximaux admissibles.

9. Arrangement (2) de limitation du courant en fonction de la température d'un accumulateur d'énergie pour de l'énergie électrique, lequel est réalisé pour mettre en oeuvre le procédé selon l'une des revendications 1 à 8.

10. Véhicule, notamment véhicule utilitaire, comprenant un arrangement (2) selon la revendication 9.
